# EUROPEAN PATENT SPECIFICATION

(11) **EP 0 598 435 B1**
(45) Date of publication and mention of the grant of the patent: **22.07.1998**
(21) Application number: 93203119.8
(22) Date of filing: 08.11.1993
(51) Int. Cl.: G11C 27/02

(54) **Discrete-time signal processing system**
Diskretzeit Signalverarbeitungssystem
Système de traitement de signal à temps discret

(30) Priority: 13.11.1992 EP 92203487
(43) Date of publication of application: 25.05.1994
(73) Proprietor: Philips Electronics N.V., 5621 BA Eindhoven (NL)
(72) Inventor: Therssen, Dieter Ernest Michel, NL-5656 AA Eindhoven (NL)
(74) Representative: Schoonheijm, Harry Barend

(56) References cited:
- EP-A- 0 512 619
- WO-A-92/10033
- IBM TECHNICAL DISCLOSURE BULLETIN vol. 21, no. 2 , July 1978 , NEW YORK US pages 452 - 455 'Time of Day Oscillator Circuit'

## Description

The invention relates to a discrete-time signal processing system comprising a signal sampling circuit and a sampling signal generator whose sampling frequency is adjustable, the sampling signal generator including an oscillator for generating a signal which has a fixed frequency, and a frequency divider.

In discrete-time signal processing circuits the sampling frequency for sampling an analog or digital input signal to be processed is often generated by converting, by means of a frequency divider, a high-frequency output signal of an oscillator into a sampling signal (clock signal) having a lower frequency. Needless to observe that the oscillation frequency of the oscillator is to be accurate and stable, which is mostly achieved by the use of a crystal oscillator. The above means that the sampling frequencies are restricted to f_{osc}/n, where f_{osc} is the oscillation frequency and n the divisor of the frequency divider. If the oscillation frequency f_{osc} is relatively low compared to the clock frequency, this denotes that the clock frequency can be adjusted only in coarse steps. Conversely, if a specific clock frequency is desired, the choice of the frequency divider will then determine the oscillation frequency which in many cases does not correspond to the frequencies belonging to the oscillator crystals which are commercially available (and thus cost effective). Furthermore, it may happen that more than one sampling frequency is necessary, such as, for example, in sampling frequency converters. This would require two (precision) oscillators, which is more expensive and more cumbersome compared to a circuit comprising a single oscillator.

It is an object of the invention to provide a discrete-time signal processing system in which, starting from a single stable oscillator frequency, a clock signal having a desired frequency is available, the ratio between the oscillator frequency and the clock frequency not being restricted to positive integers.

It is a further object of the invention to provide a discrete-time signal processing system in which the frequency spectrum of the sampled signal is not corrupted by the frequency spectrum of the sampling signal (clock signal).

It is a further object of the invention to provide a discrete-time signal processing system in which more than one desired clock frequency are derived from a fixed oscillator frequency, the ratio between oscillator frequency and clock frequency not being restricted to integers.

A discrete-time signal processing system according to the invention is characterized, in that the frequency divider is switchable between at least two states, in a first state the divisor of the frequency divider being n (n = integer) and in a second state the divisor being k, where k ≥ n+x , where x is an integer and ≥ 1, and in that a control input of the frequency divider for switching the frequency divider from one state to the other is connected to an output of a sigma-delta modulator (Σ-Δ modulator) which is supplied with a control signal for realising an effective divisor m, where n ≤ m ≤ k.

The discrete-time signal processing system according to the invention provides the possibility of selecting with a high degree of freedom a sampling frequency which is derived from a higher clock frequency, whereas the sampling frequency is not restricted to the number of integer divisors.

If with a given oscillator frequency the divisors n and k are suitably selected, usually n and n+1, a sampling signal can be generated with a desired frequency, so that its frequency spectrum is such that the frequency spectrum of the sampled signal is not corrupted by the spectrum of the sampling signal.

The invention will be further explained with reference to the embodiments represented in the drawing, in which:
Fig. 1 shows in a block diagram a discrete-time signal processing system according to the invention,
Fig. 2 shows in a block diagram a preferred embodiment of a discrete-time signal processing system according to the invention,
Fig. 3 shows in a block diagram a further embodiment of a discrete-time signal processing system according to the invention, and
Fig. 4 shows in a block diagram part of a discrete-time signal processing system suitable for a sampling frequency converter.

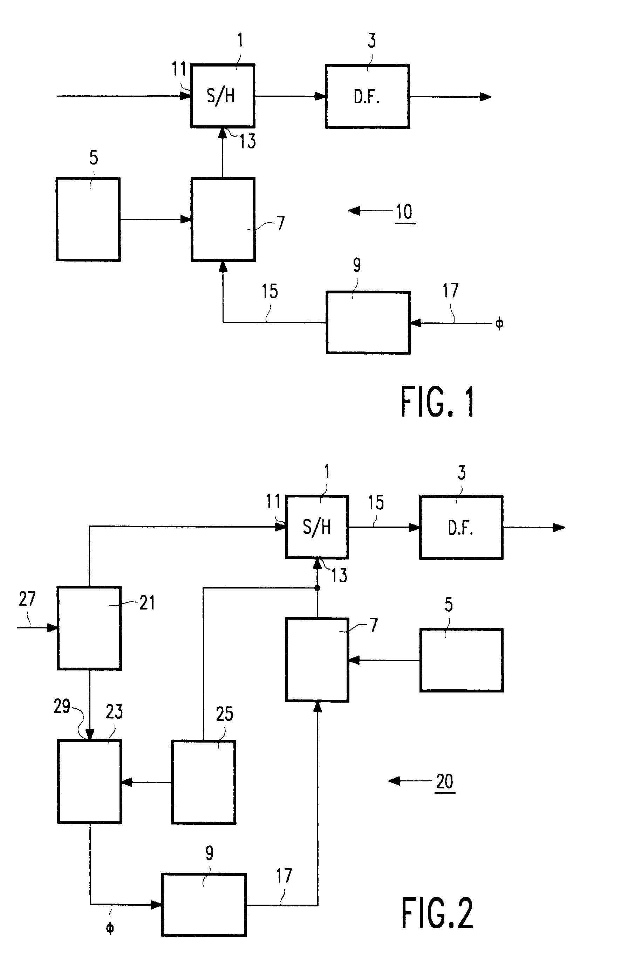

Fig. 1 shows a discrete-time signal processing system 10 according to the invention, comprising a sample-and-hold circuit 1, a decimation filter 3 connected thereto, an oscillator 5, an adjustable frequency divider 7 and a sigma-delta modulator 9 (to be denoted Σ-Δ modulator hereinafter). The sample-and-hold circuit 1 receives on its input 11 a signal to be sampled and receives on a control input 13 a sampling signal *i.e.* clock signal which is generated by means of the oscillator 5, the frequency divider 7 and the Σ-Δ modulator 9. The signal sampled by the sample-and-hold circuit 1 is further processed by the decimation filter 3.

The sampling signal to be applied to the sample-and-hold circuit 1 has a frequency which is obtained by alternately dividing the oscillation signal of the oscillator 5 in the frequency divider by either a first divisor n or a second divisor k = n+x . This achieves that the ratio m between the oscillation frequency and the sampling frequency may be situated between n and n+x (or is equal to either n or n+x if the frequency divider is not switched over). The switch-over takes place under the control of the output signal on output 15 of the Σ-Δ modulator 9 which thereto receives a control signal φ on the input 17. This control signal φ may be a DC signal, if the Σ-Δ modulator 9 is half analog and half digital, or a digital signal which may be one bit or more bits in width.

Fig. 2 shows a preferred embodiment of a discrete-time signal processing system 20 according to the invention. The system 20 comprises an input signal processor 21 and a phase comparator 23 in addition to the components 1, 3, 5, 7 and 9 described with reference to Fig. 1 and having like functions in Fig. 2. The input signal processor 21 extracts from a radio stereo signal received on input 27 the audio component, which is applied to the sample-and-hold circuit 1, and the 19 kHz pilot tone, which is applied to the input 29 of the phase comparator 23. The phase comparator 23 further receives through a divide-by-two divider 25 the output signal of the frequency divider 7 and forms from these two signals the control signal φ for the Σ-Δ modulator 9.

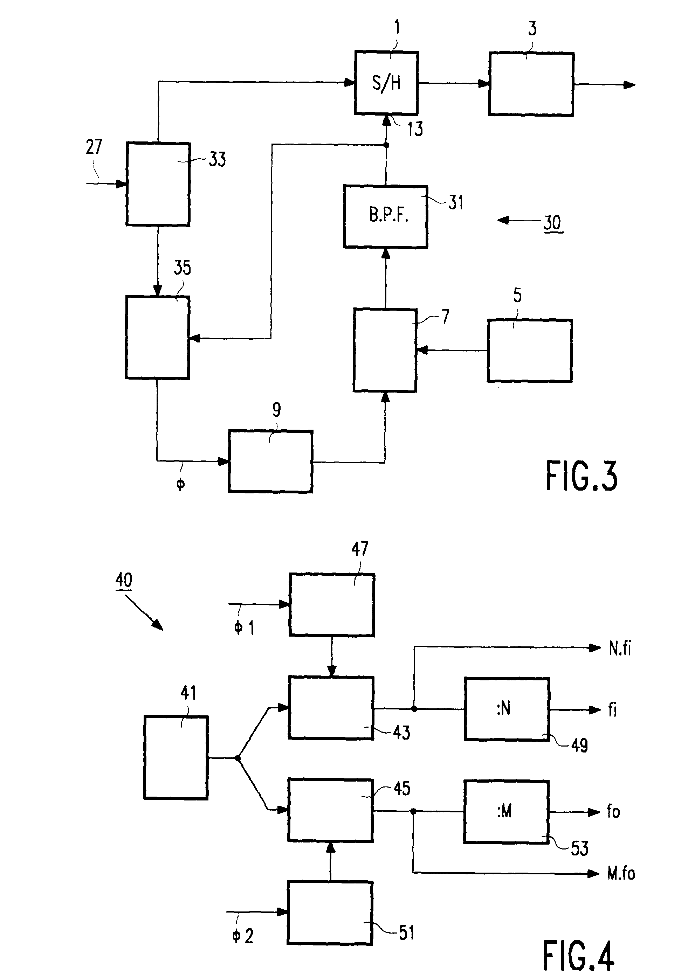

A further embodiment of a discrete-time signal processing system 30 according to the invention is shown in Fig. 3, in which all the components corresponding to those of Fig. 2 have like reference numbers and like functions. However, between the frequency divider 7 and the input 13 of the sample-and-hold circuit 1, a bandpass filter 31 is inserted, which passes a frequency band around the desired sampling frequency. This achieves an additional reduction of the high-frequency phase-noise in the sampled signal on the control input 13 of the sample-and-hold circuit 1. The bandpass filter 31 may be arranged as an analog bandpass filter, for example a ceramic filter, or as an analog phase locked loop, by which loop a large control range can be covered in a relatively simple and cost-effective manner. The signal passed by the bandpass filter 31 is applied to a phase comparator 35. Furthermore, an input signal processor 33 is provided which extracts from a received stereo signal the audio component, which is applied to the sample-and-hold circuit 1, and derives from the 19 kHz pilot tone a double frequency signal (38 kHz) which is applied to a phase comparator 35. The phase comparator 35 applies a control signal φ to the Σ-Δ modulator 9.

Fig. 4 shows a further embodiment of the invention which is pre-eminently suitable for use in a sampling frequency converter. In sampling frequency converters the sampling frequency fᵢ for the incoming signal differs from the sampling frequency fₒ for the outgoing signal. Depending on the embodiment of the sampling frequency converter, an input clock frequency fᵢ, a multiple thereof *i.e.* clock frequency N.fᵢ, as well as an output clock frequency fₒ, is necessary, or an input clock frequency fᵢ, an output clock frequency fₒ, and a multiple thereof, *i.e.* clock frequency M.fₒ. The embodiment 40 shown in Fig. 4 comprises a single (crystal) oscillator 41 whose output signal is applied with the frequency f_{osc} to two frequency dividers 43 and 45. The two frequency dividers 43 and 45 are adjustable as regards their divisor and i ii respectively, where n ≤ i ≤ n+x and m ≤ ii ≤ m+y, where n, m, x and y are positive integers. The adjustment, in this case the division by either n or n+x and either m or m+y by the frequency dividers 43 and 45 respectively, is determined by the output signal of the Σ-Δ converters 47 and 51 respectively, which thereto receive an input signal φ1 and φ2 respectively. The output signals of the frequency dividers 43 and 45 have a frequency N.fᵢ and M.fₒ respectively, so that the following holds: f_{osc} = i.N.fᵢ = ii.M.fₒ. The output signals N.fᵢ and M.fₒ are divided by further frequency dividers 49 and 53 respectively, by a divisor N and M respectively, so that output signals are obtained having the respective desired frequency fᵢ and fₒ. It should be observed that also the divisors N and M, although being positive integers in this example, need not of necessity be integers considering the above. It should be noted that a sampling frequency converter has been described in a prepublished European Patent Application EP-A-0 512 619.

## Claims

1. Discrete-time signal processing system comprising a signal sampling circuit and a sampling signal generator whose sampling frequency is adjustable, the sampling signal generator including an oscillator (5) for generating a signal which has a fixed frequency, and a frequency divider (7), characterized in that the frequency divider (7) is switchable between at least two states, in a first state the divisor of the frequency divider (7) being n (n = integer) and in a second state the divisor being k, where k ≥ n+x, where x is an integer and ≥ 1, and in that a control input of the frequency divider (7) for switching the frequency divider (7) from one state to the other is connected to an output (15) of a sigma-delta modulator (9) which is supplied with a control signal (φ) for realising an effective divisor m, where n ≤ m ≤ k.

2. Discrete-time signal processing system as claimed in Claim 1, characterized in that a phase detector (23) is provided which generates the control signal (φ) and has two inputs, the first and the second input respectively, receiving a signal related to the signal produced by the frequency divider (7) and to the signal to be sampled by the sampling circuit respectively.

3. Discrete-time signal processing system as claimed in Claim 1 or 2, characterized in that an analog filter (31) is inserted between the output of the frequency divider (7) and a control input (13) of the sampling circuit.

4. Discrete-time signal processing system as claimed in Claim 1, 2 or 3, characterized in that a decimation filter (3) is connected to the output of the sampling circuit.

5. Discrete-time signal processing system as claimed in Claim 1, 2, 3 or 4, characterized in that a clock input of the sigma-delta modulator (9) is connected either to the output of the frequency divider (7) or to the output of the analog filter (31).

6. Discrete-time signal processing system as claimed in one of the preceding Claims, characterized in that the divisor n is greater than 3 and smaller than 129.

7. Discrete-time signal processing system as claimed in Claim 6, characterized in that the divisor n is greater than 31 and smaller than 65.

8. Discrete-time signal processing system as claimed in Claim 3, characterized in that the analog filter (31) is a bandpass filter.

9. Discrete-time signal processing system as claimed in Claim 3, characterized in that the analog filter (31) comprises a phase locked loop

## Patentansprüche

1. Zeitdiskretes Signalverarbeitungssystem mit einer Signalabtastschaltung und einem Abtastsignalgenerator, dessen Abtastfrequenz einstellbar ist, wobei der Abtastsignalgenerator einen Oszillator (5) zum Erzeugen eines Signals mit einer festen Frequenz sowie einen Frequenzteiler (7) umfaßt, dadurch gekennzeichnet, daß der Frequenzteiler (7) zwischen wenigstens zwei Zuständen umschaltbar ist, wobei in einem ersten Zustand der Divisor des Frequenzteilers (7) n ist (n = ganze Zahl) und daß in einem zweiten Zustand der Divisor k ist, wobei k ≥ n + x ist, wobei x eine ganze Zahl und ≥ 1 ist, und ein Steuereingang des Frequenzteilers (7) zum Umschalten des Frequenzteilers (7) von dem einen in den anderen Zustand mit einem Ausgang (15) eines Sigma-Delta-Modulators (9) verbunden ist, dem zum Verwirklichen eines effektiven Divisors m ein Steuersignal (Φ) zugeführt wird, wobei n ≤ m ≤ k ist.

2. Zeitdiskretes Signalverarbeitungssystem nach Anspruch 1, dadurch gekennzeichnet, daß ein Phasendetektor (23) vorgesehen ist, der das Steuersignal (Φ) erzeugt und zwei Eingänge hat, und zwar den ersten und den zweiten Eingang, die ein Signal empfangen, das sich zu dem Signal verhält, das von dem Frequenzteiler (7) erzeugt wird, und zu dem Signal, das von der Abtastschaltung abgetastet werden soll.

3. Zeitdiskretes Signalverarbeitungssystem nach Anspruch 1 oder 2, dadurch gekennzeichnet, daß zwischen dem Ausgang des Frequenzteilers (7) und einem Steuereingang (13) der Abtastschaltung ein Analogfilter (31) vorgesehen ist.

4. Zeitdiskretes Signalverarbeitungssystem nach Anspruch 1, 2 oder 3, dadurch gekennzeichnet, daß mit dem Ausgang der Abtastschaltung ein Dezimierungsfilter (3) verbunden ist.

5. Zeitdiskretes Signalverarbeitungssystem nach Anspruch 1, 2, 3 oder 4, dadurch gekennzeichnet, daß ein Takteingang des Sigma-Delte-Modulators (9) entweder mit dem Ausgang des Frequenzteilers (7) oder mit dem Ausgang des Analogfilters (31) verbundne ist.

6. Zeitdiskretes Signalverarbeitungssystem nach einem der vorstehenden Ansprüche, dadurch gekennzeichnet, daß der Divisor n größer ist als 3 und kleiner als 129.

7. Zeitdiskretes Signalverarbeitungssystem nach Anspruch 6, dadurch gekennzeichnet, daß der Divisor n größer ist als 31 und kleiner als 65.

8. Zeitdiskretes Signalverarbeitungssystem nach Anspruch 3, dadurch gekennzeichnet, daß das Analogfilter (31) ein Bandpaßfilter ist.

9. Zeitdiskretes Signalverarbeitungssystem nach Anspruch 3, dadurch gekennzeichnet, daß das Analogfilter (31) eine Phasenverriegelungsschleife aufweist.

## Revendications

1. Système de traitement de signal temporel discret comprenant un circuit d'échantillonnage de signaux et un générateur de signaux d'échantillonnage dont la fréquence d'échantillonnage est réglable, le générateur de signaux d'échantillonnage comprenant un oscillateur (5) pour générer un signal qui a une fréquence fixe, et un diviseur de fréquence (7), caractérisé en ce que le diviseur de fréquence (7) est commutable entre au moins deux états, dans un premier état le diviseur du diviseur de fréquence (7) étant n (n = nombre entier) et dans un deuxième état le diviseur étant k, où k ≥ n+x, où x est un nombre entier et ≥ 1, et en ce qu'une entrée de commande du diviseur de fréquence (7) pour commuter le diviseur de fréquence (7) d'un état à l'autre est connectée à une sortie (15) d'un modulateur sigma-delta (9) auquel est appliqué un signal de commande (φ) pour réaliser un diviseur efficace m,
où n ≤ m ≤ k.

2. Système de traitement de signal temporel discret suivant la revendication 1, caractérisé en ce qu'un détecteur de phase (23) est prévu qui génère le signal de commande (φ) et comporte deux entrées, respectivement la première et la deuxième entrées, recevant un signal lié respectivement au signal produit par le diviseur de fréquence (7) et au signal à échantillonner par le circuit d'échantillonnage.

3. Système de traitement de signal temporel discret suivant la revendication 1 ou 2, caractérisé en ce qu'un filtre analogique (31) est intercalé entre la sortie du diviseur de fréquence (7) et une entrée de commande (13) du circuit d'échantillonnage.

4. Système de traitement de signal temporel discret suivant la revendication 1, 2 ou 3, caractérisé en ce qu'un filtre de décimation (3) est connecté à la sortie du circuit d'échantillonnage.

5. Système de traitement de signal temporel discret suivant la 5 revendication 1, 2, 3 ou 4, caractérisé en ce qu'une entrée d'horloge du modulateur sigma-delta (9) est connectée soit à la sortie du diviseur de fréquence (7) soit à la sortie du filtre analogique (31).

6. Système de traitement de signal temporel discret suivant l'une quelconque des revendications précédentes, caractérisé en ce que le diviseur n est supérieur à 3 et inférieur à 129.

7. Système de traitement de signal temporel discret suivant la revendication 6, caractérisé en ce que le diviseur n est supérieur à 31 et inférieur à 65.

8. Système de traitement de signal temporel discret suivant la revendication 3, caractérisé en ce que le filtre analogique (31) est un filtre passe-bande.

9. Système de traitement de signal temporel discret suivant la revendication 3, caractérisé en ce que le filtre analogique (31) comprend une boucle à verrouillage de phase.
